# EUROPÄISCHE PATENTSCHRIFT

(11) **EP 2 586 280 B1**
(45) Veröffentlichungstag und Bekanntmachung des Hinweises auf die Patenterteilung: **04.05.2016**
(21) Anmeldenummer: 11767898.7
(22) Anmeldetag: 22.06.2011
(51) Int. Cl.: H05K 5/00, B60R 16/023, H01R 12/72, H05K 1/11, H01R 13/639, H01R 13/516, H05K 5/06, H05K 7/00, H05K 13/04

(54) **ELEKTRISCHE BAUGRUPPE FÜR EIN KRAFTFAHRZEUG GEEIGNET ZUR KONTAKTIERUNG MIT EINEM STECKER**
ELECTRICAL ASSEMBLY FOR A MOTOR VEHICLE THAT IS SUITABLE FOR CONTACTING WITH A CONNECTOR
ENSEMBLE ÉLECTRIQUE POUR UN VÉHICULE AUTOMOBILE, APPROPRIÉ POUR LA CONNEXION AVEC UN CONNECTEUR

(30) Priorität: 25.06.2010 DE 102010025086
(43) Veröffentlichungstag der Anmeldung: 01.05.2013
(73) Patentinhaber: Continental Automotive GmbH, 30165 Hannover (DE)
(72) Erfinder: CHRISTOPH, Markus, 93055 Regensburg (DE); PLANKL, Christian, 93055 Regensburg (DE); WÖRLE, Engelbert, 86556 Kühbach (DE); BAUMGARTNER, Joachim, 93173 Wenzenbach (DE)
(74) Vertreter: Büchner, Jörg
(86) Internationale Anmeldenummer: PCT/DE2011/001450
(87) Internationale Veröffentlichungsnummer: WO 2012/010152

(56) Entgegenhaltungen:
- EP-A2- 1 104 228
- DE-A1- 3 609 684
- DE-A1- 4 005 113
- DE-A1- 19 533 723
- DE-A1-102005 003 448

## Beschreibung

Die Erfindung betrifft eine elektrische Baugruppe für ein Kraftfahrzeug geeignet zur Kontaktierung mit einem Stecker gemäß dem Oberbegriff von Anspruch 1.

Gerade für den Einbau in Kraftfahrzeugen muss die elektrische Baugruppe zumindest nach dem anschließen des Steckers feuchtigkeitsdicht sein, um vor den Umwelteinflüssen, insbesondere Feuchtigkeit und Schmutz, geschützt zu sein. Dazu wurden zunehmend Steckerpins verwendet, die als Einlegeteile vom Kunststoff des Steckerbereichs gespritzt und in die Leiterplatte eingepresst oder der Leiterplatte verlötet wurden. So zeigt beispielsweise die DE 10 2004 002562 A1 oder die EP 712 265 D1 eine entsprechende Baugruppe.

Darüber hinaus sind insbesondere aus der Computertechnik für austauschbare Steckkarten und Speicherkarten das Prinzip der Randkontaktierung (edge connector) bekannt, bei dem elektrisch kontaktierbare Kontaktflächen auf einem Träger, beispielsweise einer Leiterplatte ausgebildet und üblicherweise mit Federkontakten kontaktiert werden. In der DE 10 2005 0 03448 A1 wird darüber hinaus für ein Steuergerät für ein Kraftfahrzeug mit einer außerhalb eines Gehäuse angeordneten Leiterplatte eine solche Randkontaktierung ebenfalls vorgeschlagen, wobei bei dieser Ausgestaltung nur einzelne auf der Leiterplatte angeordnete elektrische Bauelemente, nicht aber die Leiterplatte selbst durch ein Gehäuse von Umgebungseinflüssen geschützt sind, sofern nicht zumindest durch Anstecken des Steckers das Gehäuse auch im Steckerbereich abgeschlossen ist. Dies erhöht die Kosten für die Leiterplatte und Fertigung erheblich und ist somit für eine kostengünstige Massenfertigung nicht geeignet.

Die Aufgabe der vorliegenden Erfindung ist es daher, eine verbesserte Baugruppe sowie Verfahren zur elektrischen Kontaktierung einer elektrischen Baugruppe für ein Kraftfahrzeug mit zumindest einem Stecker und einer bevorzugten Ausgestaltung eines entsprechenden Steckers vorzustellen.

Diese Aufgabe wird durch die Merkmale der unabhängigen Ansprüche 1 und 9 gelöst. Vorteilhafte Weiterbildungen der Erfindung ergeben sind aus den Unteransprüchen, wobei auch Kombinationen und Weiterbildungen einzelner Merkmale miteinander denkbar sind.

Ein wesentlicher Gedanke der Erfindung besteht darin, dass das Gehäuse der Baugruppe eine innere Kammer und eine zum Steckerbereich hin gerichtete Kontaktierkammer aufweist, wobei zumindest eine innere Wand zur Trennung zwischen innerer Kammer und Kontaktierkammer vorgesehen ist und Leiterplatte mit den elektrischen Bauelementen in der inneren Kammer angeordnet und nur der aus der Leiterplatte ausgeformte Kontaktierbereich durch die innere Wand hindurch in die Kontaktierkammer ragt. Damit wird das Gehäuse der Baugruppe so gestaltet, dass das Gehäuse der Baugruppe die Leiterplatte auch schon vor dem Anstecken des Steckers außerhalb des Kontaktbereichs vollständig umschließt, das heißt der wesentliche Teil der Leiterplatte mit den Baugruppen schon vor dem Anstecken des Steckers besser geschützt ist und durch den Stecker nur noch zusätzlich der Kontaktbereich mit den Kontaktflächen abgedichtet werden muss.

Die Erfindung wird nun nachfolgend anhand eines Ausführungsbeispieles unter Zuhilfenahme der Figuren näher erläutert. Im Folgenden können für funktional gleiche und/oder gleiche Elemente mit den gleichen Bezugsziffern bezeichnet sein.

Es zeigen
- Figur 1:: Bestandteile der Baugruppe vor dem Zusammenbau
- Figur 2:: Bestandteile der Baugruppe gemäß Figur 1 aus entgegengesetzter Blickrichtung
- Figur 3:: horizontaler Schnitt durch die zusammengebaute Baugruppe
- Figur 4: vertikaler Schnitt durch die zusammengebaute Baugruppe
- Figur 5: Baugruppe mit angestecktem Stecker teils aufgeschnitten
- Figur 6: Detailansicht aus Figur 5
- Figur 7: Detailansicht der Kontaktierung unter Weglassung des sonstigen Steckers
- Fig. 8a: Randkontaktierung mit Kontaktflächen bis an den Rand des Kontaktbereichs
- Fig. 8b: Randkontaktierung mit Kontaktflächen zurückversetzt vom Rand
- Figur 9: Ausgestaltung des Steckers mit einschiebbarem Träger der Kontaktelemente
- Figur 10: Ausgestaltung des Steckers mit alternativem Träger für andere Kontaktelemente
- Fig. 11:: weiterer Schnitt durch die Baugruppe im Bereich der Kontaktierkammer mit Blick hin auf die innere Wand

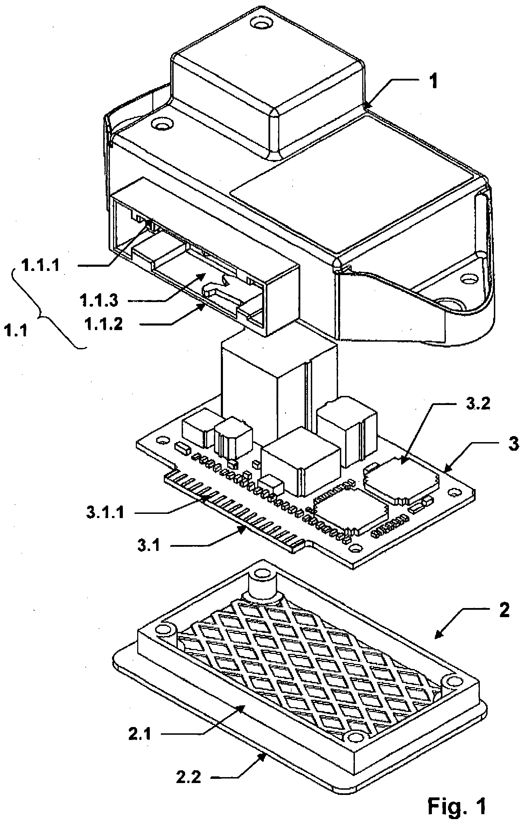

Figur 1 zeigt in einer skizzenhaften Explosionsdarstellung die Bestandteile der Baugruppe vor dem Zusammenbau. So besteht die Baugruppe aus einem Gehäuse mit einer Gehäuseoberteil 1 und einer Gehäuseunterteil 2, wobei die Begriffe oben und unten im Zusammenhang mit der Beschreibung entsprechend der in Figur 1 gewählten Darstellung verwendet werden, ohne dass es für die Erfindung wesentlich wäre, welches Gehäuseteil nun tatsächlich oben beziehungsweise unten angeordnet und insbesondere wo der Steckerbereich ausgebildet ist. Die gezeigten und beschriebenen Ausführungsbeispiele sind insoweit rein exemplarisch und nicht beschränkend.

In diesem Ausführungsbeispiel befindet sich der Steckerbereich 1.1 am Gehäuseoberteil 1. Das Gehäuseunterteil 2 ist ein Deckel ausgestaltet, welcher eine innere Wand 2. 1 zur Bildung der zurückversetzten Kontaktierkammer 1.3 (vergleiche folgende Figuren) sowie eine Überstand 2.2 zum Schließen der Kontaktierkammer 1.3 in Richtung der Gehäuseunterseite aufweist. Zwischen Gehäuseoberteil 1 und Gehäuseunterteil 2 ist die Leiterplatte 3 angeordnet, wobei an der Leiterplatte ein zungenförmiger Kontaktierbereich 3.1 ausgeformt ist, welche eine räumliche Trennung des Kontaktierbereichs von der restlichen Leiterplatte 3 mit den darauf angeordneten elektrischen Bauelementen 3.2 ermöglicht.

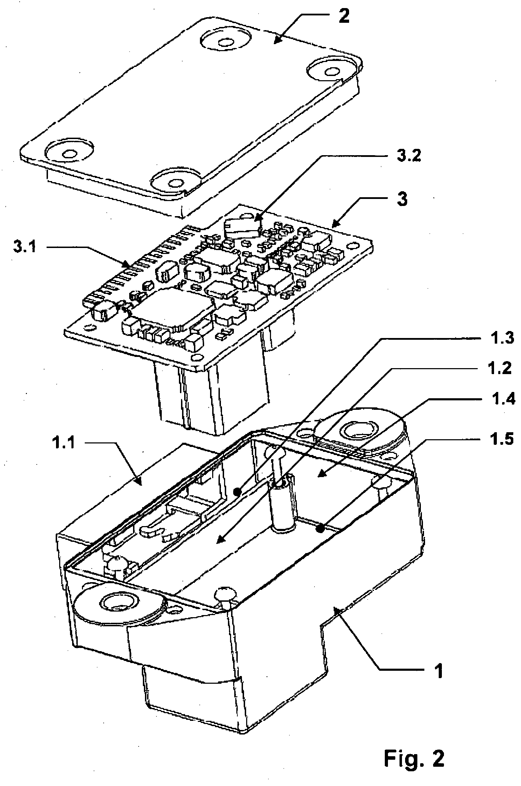

Figur 2 zeigt nun aus der entgegengesetzten Blickrichtung die Bestandteile der Baugruppe gemäß Figur 1. Deutlich ist dabei insbesondere die innere Wand 1.2 in Gehäuseoberteil 1 (hier in Fig. 2 nun unten !) zu erkennen. Diese innere Wand 1.2 unterteilt das Gehäuseoberteil 1 in eine innere Kammer 1.5 und die Kontaktierkammer 1. 3. Zudem kann in Figur 2 erkannt werden, dass die Öffnung 1.4 des Gehäuseoberteils 1 so dimensioniert ist, dass die Leiterplatte 3 mitsamt gegenüberstehenden Kontaktierbereich 3.1 direkt senkrecht in das Gehäuseoberteil 1 eingeführt beziehungsweise das Gehäuseoberteil 1 direkt aufgesetzt werden kann, da der Kontaktierbereich 3.1 vom äußeren Steckerbereich 1.1 zurückversetzt in der Kontaktierkammer 1. 3 angeordnet ist.

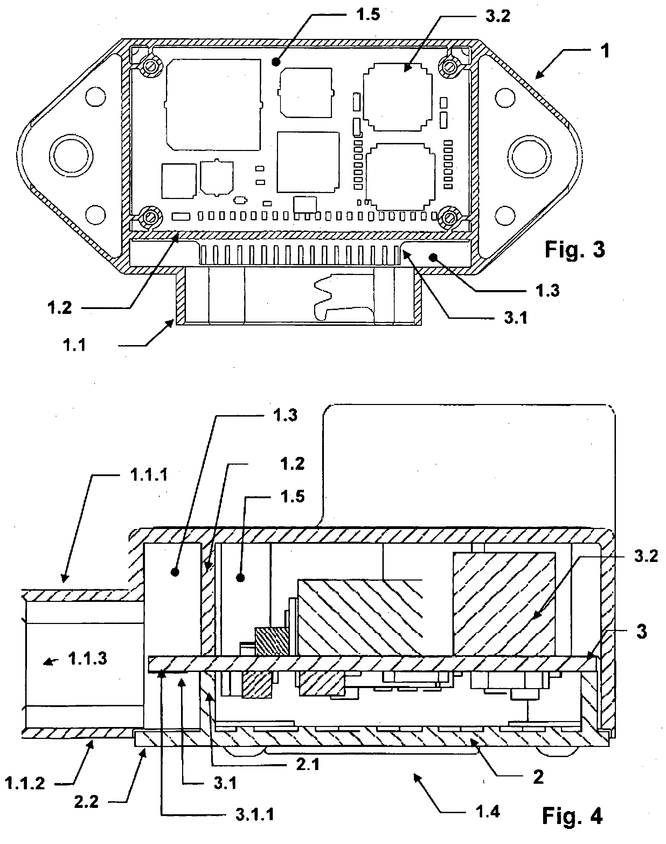

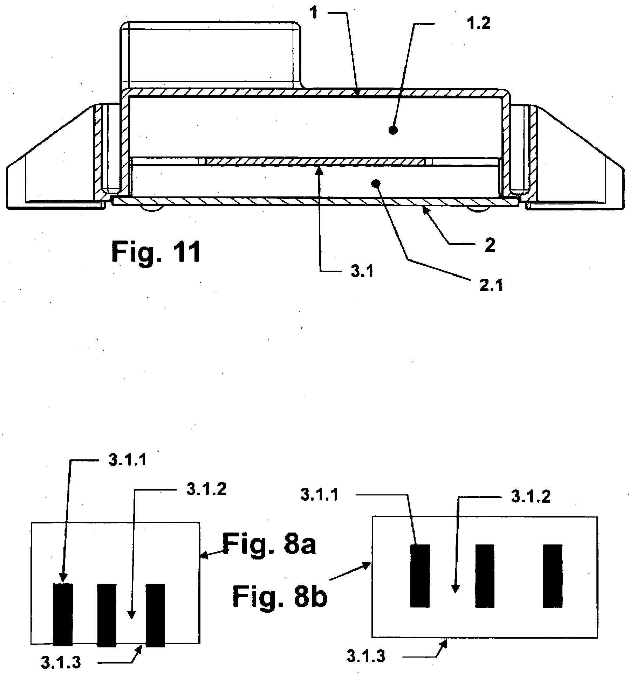

Noch besser zu erkennen ist diese Unterteilung in den Schnitt-Darstellungen der zusammengesetzten Baugruppe in Figur 3 und Figur 4. Figur 3 zeigt dabei einen horizontalen Schnitt durch die mit der Leiterplatte 3 montierte Baugruppe. In dieser Darstellung in Figur 3 ergeben besonders deutlich die Unterteilung des Gehäuseoberteils 1 in die innere Kammer 1.5, in welcher die elektronischen Bauelemente 3.2 jederzeit auch bei abgestecktem Stecker durch die innere Wand 1.2 von der Umgebung getrennt und geschützt sind. Ergänzend zeigt auch Fig. 11 nochmal besonders deutlich, dass die beiden inneren Wände 1.2 und 2.1 bis zur dazwischen eingeschlossenen Leiterplatte 3 ragen und so eine Trennung der Kontaktierkammer von der inneren Kammer bilden.

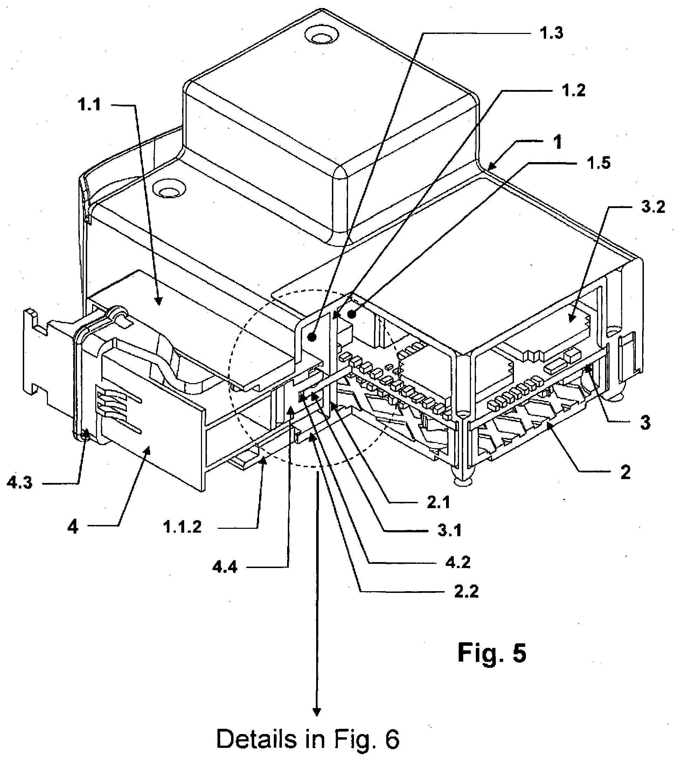

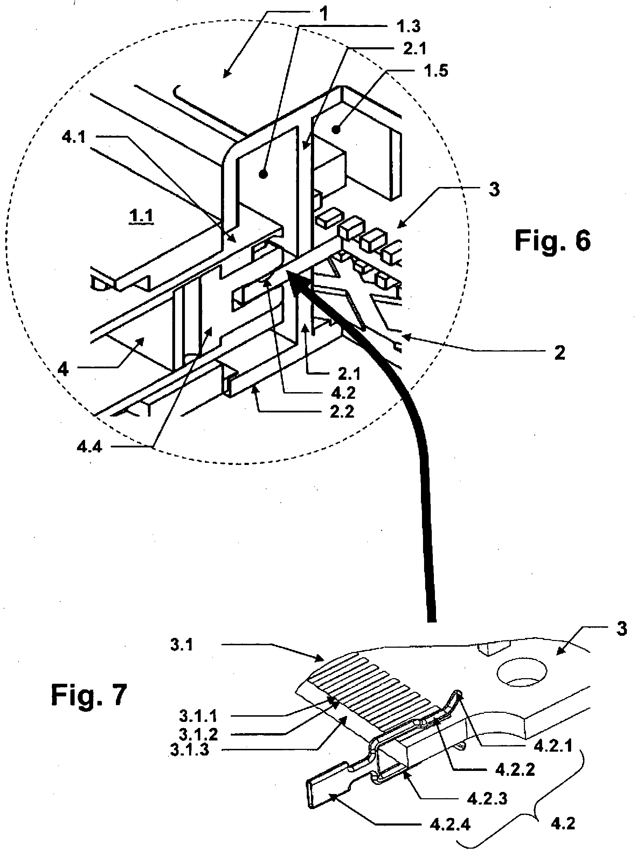

Die inneren Wände 2.1 und 1.2 von Gehäuseoberteil 1 und Gehäuseunterteil 2 sind dabei in der bevorzugten Ausgestaltung in einer gemeinsamen Ebene angeordnet, wie in den Figuren 5 und 6 besonders anschaulich dargestellt ist. Die Wände 2.1 und 1.2 stützen sich damit gegeneinander auf der Leiterplatte 3 ab, ohne das es zu einer Biegebelastung der Leiterplatte 3 führen würde.

Die inneren Wände 2.1 und 1.2 sind vorzugsweise auch mit dem Kunststoffmaterial des Gehäuseoberteils 1 beziehungsweise Gehäuseunterteils 2 stoffschlüssig verbunden, vorzugsweise einstückig daraus ausgeformt oder als Zwei-Komponenten-Spritzguss aus zwar anderem Kunststoffmaterial, jedoch stoffschlüssig beim Spritz- und Pressvorgang damit verbunden ausgestaltet.

In einer besonders bevorzugten Weiterbildung kann der auf der Leiterplatte aufliegende Rand der inneren Wände 2.1 und 1.2 auch mit je einem Dichtungselement versehen werden. Diese Dichtungselemente können zudem in einer weiteren Ausgestaltung im unverbauten Zustand auch ein Übermaß aufweisen, welches mit dem Zusammenbau des Gehäuses und dem Zusammenpressen der beiden Gehäuseteile und der dazwischenliegenden Leiterplatte abgebaut und so eine besonders gute Abdichtung erreicht wird.

Selbst wenn aber ein geringer Luftspalt zwischen Leiterplatte und den inneren Wänden der Gehäuseteile verbleibt, führt dies zu einem gewissen Schutz der Elektronik in der inneren Kammer, was ausreichend für die Lagerung solcher Baugruppen vor deren Verbau beim Fahrzeughersteller oder in Werkstätten ist. Durch die oben beschriebenen Dichtungselemente kann der Schutz natürlich noch deutlich verbessert werden, wobei eine absolute Druckdichtheit in der Regel nicht erforderlich ist, da die Gehäuse im Inneren in aller Regel noch ein Druckausgleichselement aufweisen, so dass keine zu massiven Druckunterschiede zu erwarten sind.

Nur der Kontaktierbereich 3.1 der Leiterplatte 3 ist in der Kontaktierkammer 1.3 angeordnet und kann bei nicht angestecktem Stecker durch die vordere Öffnung 1.1.3 des Steckerbereichs 1.1 Umgebungseinflüssen ausgesetzt sein.

Die vertikale Schnittdarstellung in Figur 4 ergänzt die Veranschaulichung nochmals und zeigt besonders schön das Zusammenspiel der inneren Wand 1.2 des Gehäuseoberteils 1 mit der seitlichen Wand 2.1 am Gehäuseunterteil 2, zwischen denen die Leiterplatte 3 nach dem Zusammenbau der Baugruppe in der inneren Kammer 1.5 bereits von Umwelteinflüssen geschützt ist.

Zudem ist gut zu erkennen, dass die Öffnung 1.4 auf der Unterseite des Gehäuseoberteils so dimensioniert ist, dass die Leiterplatte 3 unmittelbar senkrecht eingeführt werden kann. Andererseits ist gut zu erkennen, dass die Öffnung 1.4 durch das Gehäuseunterteil 2, insbesondere eben auch durch die Überstand 2.2 komplett auch bis in den Bereich der Kontaktierkammer 1.3 verschlossen wird.

Figur 5 zeigt nun die Baugruppe mit angestecktem Stecker 4 abschnittsweise aufgebrochen, wobei Figur 6 den in Figur 5 gestrichelt markierten Bereich der elektrischen Kontaktierung noch vergrößert darstellt und hier maßgeblich insbesondere auf die Figur Bezug genommen werden soll. Auch in diesen Figuren ist das Zusammenspiel der inneren Wand 1.2 des Gehäuseoberteils 1 mit der seitlichen Wand 2.1 am Gehäuseunterteil 2 zur Bildung der inneren Kammer 1.5 für die elektrische Bauelemente 3. 2 auf der Leiterplatte 3 der davon getrennten Kontaktierkammer 1.3. Gut zu erkennen ist, wie der Stecker 4 mit seinem Träger 4.4 den Kontaktierbereich 3. 1 der Leiterplatte 3 beidseitig umgreift, wobei im Inneren die Kontaktelemente 4.2 des Steckers 4 die Kontaktflächen 3.1.1 elektrisch kontaktieren, wie dies nachfolgend in Figur 7 noch besser zu erkennen ist.

Figur 7 zeigt nämlich ausschließlich die Leiterplatte 3 mit den Kontaktflächen 3.1.1 und den dazwischen liegenden isolierenden Freiräumen 3.1.2 sowie eine bevorzugte Ausgestaltung eines Kontaktelements 4. 2 unter Weglassung sämtlicher Gehäuse der Baugruppe als auch des Steckers, so dass die eigentliche elektrische Kontaktierung sichtbar wird.

Ein Stecker weist dabei vorzugsweise eine Vielzahl von identischen Kontaktelementen 4.2 auf. Jedes Kontaktelement 4.2 weist dabei einen Federarm mit einem gegenüber der Dicke der Leiterplatte 3 leicht aufgeweiteten und von der Leiterplatte wegweisend geöffneten Einführbereich 4.2.1, einen demgegenüber engeren, evt. mit leichterer Presspassung zur Leiterplatte 3 dimensionierten Kontaktbereich 4.2.2 des Federarms und vorzugsweise einen Gegenarm 4.2.3 zum Gegendrücken auf, wobei der Gegenarm 4.2.3 starr oder auch identisch als elastischer Federarm ausgebildet sein kann.

Zudem weist jedes Kontaktelement. 4.2 eine Anschlusszone 4.2.4 auf, mit dem das Kontaktelement 4.2 im Stecker 4 mit (nicht näher gezeigten) elektrischen Anschlusskabeln verbunden ist.

Die Figuren 8a und 8b skizzieren unterschiedliche Ausgestaltungen der für die Erfindung ja bevorzugten Randkontaktierung (edge connection), wobei in Figur 8a die Kontaktflächen 3.1.1 bis an den Rand 3.1.3 des Kontaktbereichs 3.1 bezogen, evt. sogar um diesen Rand 3.1.3 umlaufend und bis zur Unterseite der Leiterplatte 3 hin durchgängig elektrisch verbunden ausgestaltet sein können. Alternativ können aber natürlich auch die Kontaktflächen 3.1.1 mit einem gewissen Abstand vom Rand 3.1.3 angeordnet sein.

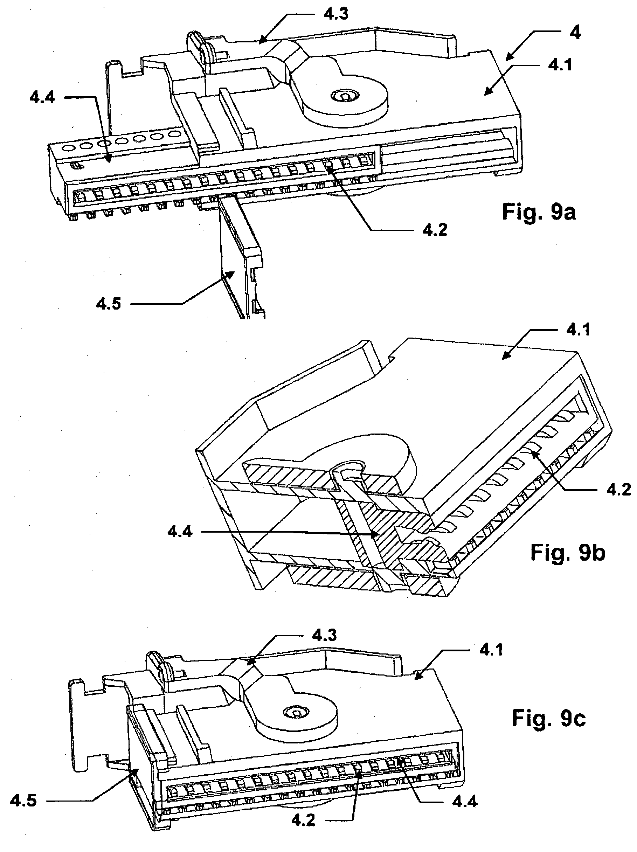

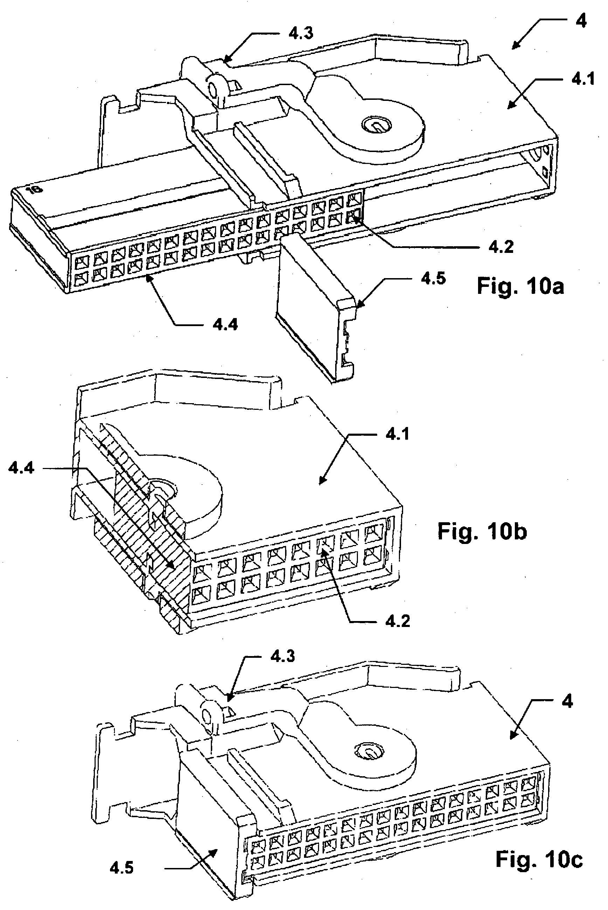

Die Figuren 9a, 9b und 9c zeigen eine besonders bevorzugte Ausgestaltung des Steckers 4. So besteht der Stecker 4 aus einem äußeren Steckergrundkörper 4.1, welcher entsprechend dem Steckerbereich 1.1 geformt ist und in denen in bevorzugter Weise ein davon getrennter Träger 4.4 mit den Kontaktelementen 4.2 einschiebbar ist. Der Träger 4.4 kann durch eine Verschlußplatte 4.5 im Steckergrundkörper 4.1 fixiert werden. Der besondere Vorteil eines solchen Steckers mit separatem Träger 4.4 wird jedoch erst in der Zusammenschau mit Figur 10 deutlich, wo nämlich ein alternativer Träger 4.4 mit herkömmlichen Kontakten für Pinkontakte eingeführt wird. Somit können mit einem Stecker 4 und austauschbaren Trägern 4.4 unterschiedliche Baugruppen angeschlossen werden.

Zudem ist am Stecker 4 vorzugsweise ein Verriegelungselement 4.3 ausgebildet, indem der Stecker 4 nach dem Anstecken an das Gehäuse an das Gehäuse zusätzlich angepresst und am Gehäuse verriegelt wird. Dadurch kann die gewünschte feuchtigkeitsdichte Einheit aus Baugruppe und Stecker auch bei Erschütterungen im Fahrbetrieb bei Einsatz einer solchen Baugruppe im Kraftfahrzeug, beispielsweise als ein Steuergerät für Motorsteuerungen, ABS-Steuerungen oder Airbagsteuerungen verwendet werden.

### Bezugszeichenliste

- 1: Gehäuseoberteil
- 1.1: Steckerbereich am Gehäuseoberteil
- 1.1.1: obere Seite des Steckerbereichs
- 1.1.2: untere Seite des Steckerbereichs
- 1.1.3: vorderer offener Bereich des Steckerbereichs
- 1.2: innere Wand zur Bildung einer zurückversetzten Kontaktierkammer 1.3
- 1.3: vom Steckerbereich zurückversetzte Kontaktierkammer
- 1.4: Öffnung des Gehäuseoberteils zum Einführen der Leiterplatte
- 1.5: innere Kammer
- 2: Gehäuseunterteil
- 2.1: innere Wand zur Bildung der zurückversetzten Kontaktierkammer 1.3
- 2.2: Überstand am Gehäuseunterteil zum Schließen der Öffnung 1.4
- 3: Leiterplatte
- 3.1: Kontaktierbereich
- 3.1.1: Kontaktfläche
- 3.1.2: isolierender Freiraum zwischen den einzelnen Kontaktflächen
- 3.1.3: vorderer Rand des Kontaktierbereichs
- 3.2: Bauelemente auf der Leiterplatte
- 4: Stecker
- 4.1: Steckergrundkörper
- 4.2: Kontaktelemente
- 4.2.1: Einführbereich des Federarms des Kontaktelements
- 4.2.2: Kontaktbereich des Federarms des Kontaktelements
- 4.2.3: Gegenarm des Kontaktelements zum Gegendrücken
- 4.2.4: Anschlusszone des Kontaktelements
- 4.3: Verriegelungselement am Stecker
- 4.4: einschiebbarer Träger der Kontaktelemente
- 4.5: Verschlußplatte zurm Arretieren des Trägers 4.4 im Steckergrundkörper

## Patentansprüche

1. Elektrische Baugruppe für ein Kraftfahrzeug geeignet zur Kontaktierung mit einem Stecker, wobei
die elektrische Baugruppe ein Gehäuse und
eine Leiterplatte mit elektrischen Bauelementen und Leiterbahnen
sowie erste, für den Stecker zugängliche Kontaktelemente umfasst und diese an der Baugruppe befindlichen ersten Kontaktelemente als Kontaktflächen auf der Leiterplatte ausgebildet sind, indem ein Kontaktierbereich der Leiterplatte mit Leiterbahnen zu diesen Kontaktflächen ausgebildet ist, wobei die an der Baugruppe befindlichen ersten Kontaktelemente als Randkontakte auf der Leiterplatte ausgebildet sind, **dadurch gekennzeichnet, dass**
das Gehäuse der Baugruppe eine innere Kammer (1.5) und eine zu einem Steckerbereich (1.1) hin gerichtete Kontaktierkammer (1.3) aufweist, wobei zumindest eine innere Wand (1.2, 2.1) zur Trennung zwischen innerer Kammer (1.5) und Kontaktierkammer (1.3) vorgesehen ist und die Leiterplatte (3) mit den elektrischen Bauelementen (3.2) in der inneren Kammer (1.5) angeordnet ist und nur der auf der Leiterplatte ausgeformte Kontaktierbereich (3.1) durch die innere Wand (1.2) hindurch in die Kontaktierkammer (1.3) ragt.

2. Elektrische Baugruppe nach Anspruch 1, **dadurch gekennzeichnet, dass** das Gehäuse aus einem Gehäuseoberteil (1) und einem Gehäuseunterteil (2) besteht und jeweils am Gehäuseoberteil als auch am Gehäuseunterteil jeweils eine innere Wand (1.2,2.1) vorgesehen ist und die Leiterplatte (3) zwischen Gehäuseoberteil (1) und Gehäuseunterteil (2) fixiert ist, wobei die inneren Wände (2.1,2.1) jeweils zur Leiterplatte (3) ragen und gemeinsam die innere Wand zur Abtrennung der Kontaktierkammer (1.3) von der inneren Kammer (1.5) bilden.

3. Elektrische Baugruppe nach Anspruch 2, **dadurch gekennzeichnet, dass** die inneren Wände (2.1,1.2) in einer gemeinsamen Ebene angeordnet sind.

4. Elektrische Baugruppe nach Anspruch 2 oder 3, **dadurch gekennzeichnet, dass** die inneren Wände (2.1,1.2) mit dem Kunststoffmaterial des Gehäuseoberteils (1) und Gehäuseunterteils (2) verbunden, vorzugsweise einstückig daraus ausgeformt sind

5. Elektrische Baugruppe nach einem der vorangehenden Ansprüche, **dadurch gekennzeichnet, dass** das Gehäuse (1,2) der Baugruppe so geformt ist, dass der Stecker (4) so ansteckbar ist, dass mit dem Anstecken des Steckers eine feuchtigkeitsdichte Einheit aus Baugruppe und Stecker entsteht.

6. Elektrische Baugruppe nach Anspruch 5, **dadurch gekennzeichnet, dass** der Kontaktbereich (3.1) der Baugruppe aus dem Gehäuse geführt oder durch eine Aussparung (1.1.3) des Gehäuses von außen kontaktierbar ist und
das Gehäuse (1,2) die Leiterplatte (3) außerhalb des Kontaktbereichs vollständig umschließt.

7. Elektrische Baugruppe nach einem der vorangehenden Ansprüche, **dadurch gekennzeichnet, dass** das Gehäuse aus einer Gehäuseschale (1) und einem Gehäusedeckel (2) gebildet ist, wobei an der Gehäuseschale (1) ein umlaufender Steckerkragen (1.1) zum Anschließen eines Steckers (4) vorgesehen ist und die Gehäuseschale (1) eine zumindest der Fläche der Leiterplatte (3) entsprechende Öffnung (1.4) aufweist, wobei diese Öffnung (1.4) durch den Gehäusedeckel (2) vollständig verschließbar ist.

8. Kraftfahrzeug mit einer Baugruppe gemäß einem der Ansprüche 1 bis 7.

9. Verfahren zur Herstellung einer Baugruppe nach Anspruch 2, wobei die elektrische Baugruppe ein Gehäuse und eine Leiterplatte mit elektrischen Bauelementen und Leiterbahnen aufweist,
erste, im Inneren des Gehäuses angeordnete, für den Stecker durch einen Steckerbereich (1.1) hindurch jedoch zugängliche Kontaktelemente vorgesehen sind und diese an der Baugruppe befindlichen ersten Kontaktelemente als Kontaktflächen auf der Leiterplatte ausgebildet sind, indem ein Kontaktierbereich der Leiterplatte mit Leiterbahnen zu diesen Kontaktflächen ausgebildet ist und die an der Baugruppe befindlichen ersten Kontaktelemente als Randkontakte auf der Leiterplatte ausgebildet sind,
das Gehäuse der Baugruppe eine innere Kammer (1.5) und eine zum Steckerbereich hin gerichtete Kontaktierkammer (1.3) bildet, wobei zumindest eine innere Wand (1.2, 2.1) zur Trennung zwischen innerer Kammer (1.5) und Kontaktierkammer (1.3) vorgesehen ist und Leiterplatte (3) mit den elektrischen Bauelementen (3.2) in der inneren Kammer (1.5) angeordnet und nur der aus der Leiterplatte ausgeformte Kontaktierbereich (3.1) durch die innere Wand (1.2) hindurch in die Kontaktierkammer (1.3) ragt,
das Gehäuse aus einem Gehäuseoberteil und einem Gehäuseunterteil besteht und jeweils am Gehäuseoberteil als auch am Gehäuseunterteil eine innere Wand vorgesehen ist und durch Schließen des Gehäuses die Leiterplatte zwischen Gehäuseoberteil und Gehäuseunterteil fixiert ist, wobei die inneren Wände jeweils zur Leiterplatte ragen und gemeinsam die innere Wand zur Abtrennung einer Kontaktierkammer (1.3) von einer inneren Kammer (1.5) bilden.

## Claims

1. An electrical assembly for a motor vehicle, suitable for contacting with a connector, wherein
the electrical assembly comprises a housing and
a circuit board including electrical components and conducting tracks,
and first contact elements that are accessible to the connector, and these first contact elements located on the assembly are configured as contact surfaces on the circuit board, in that a contacting area of the circuit board is configured with conducting tracks to form these contact surfaces, wherein the first contact elements located on the assembly are configured as edge contacts on the circuit board, **characterized in that**
the housing of the assembly has an inner chamber (1.5) and a contacting chamber (1.3) directed towards a connector area (1.1), wherein at least one inner wall (1.2, 2.1) is provided to separate the inner chamber (1.5) from the contacting chamber (1.3), and the circuit board (3) including the electrical components (3.2) is arranged in the inner chamber (1.5), and only the contacting area (3.1) formed on the circuit board protrudes through the inner wall (1.2) into the contacting chamber (1.3).

2. The electrical assembly according to Claim 1, **characterized in that** the housing consists of an upper housing part (1) and a lower housing part (2), and inner walls (1.2, 2.1) are respectively provided on the upper housing part and on the lower housing part and the circuit board (3) is fixed between the upper housing part (1) and the lower housing part (2), wherein the inner walls (2.1, 1.2) respectively extend to the circuit board (3), jointly forming the inner wall which separates the contacting chamber (1.3) from the inner chamber (1.5).

3. The electrical assembly according to Claim 2, **characterized in that** the inner walls (2.1, 1.2) are arranged in a joint plane.

4. The electrical assembly according to Claim 2 or 3, **characterized in that** the inner walls (2.1, 1.2) are connected to the plastic material of the upper housing part (1) and the lower housing part (2), preferably being integrally formed therefrom.

5. The electrical assembly according to any one of the preceding claims, **characterized in that** the housing (1, 2) of the assembly is shaped such that the connector (4) can be plugged in such that a moisture-proof assembly-connector unit is obtained when the connector is plugged in.

6. The electrical assembly according to Claim 5, **characterized in that** the contact area (3.1) of the assembly extends to the outside of the housing or can be contacted from outside through a recess (1.1.3) of the housing, and the housing (1, 2) entirely encloses the circuit board (3) outside the contact area.

7. The electrical assembly according to any one of the preceding claims, **characterized in that** the housing is formed from a housing tray (1) and a housing lid (2), wherein a peripheral connector collar (1.1) that serves to plug in a connector (4) is provided on the housing tray (1) and the housing tray (1) has an opening (1.4) corresponding at least to the surface area of the circuit board (3), wherein this opening (1.4) can be completely closed by the housing lid (2).

8. A motor vehicle having an assembly according to any one of Claims 1 to 7.

9. A method of manufacturing an assembly according to Claim 2, wherein
the electrical assembly comprises a housing and a circuit board including electrical components and conducting tracks,
first contact elements arranged inside the housing but which are accessible to the connector through a connector area (11) are provided and these first contact elements located on the assembly are configured as contact surfaces on the circuit board, in that a contacting area of the circuit board is configured with conducting tracks to form these contact surfaces and the first contact elements located on the assembly are configured as edge contacts on the circuit board,
the housing of the assembly has an inner chamber (1.5) and a contacting chamber (1.3) directed towards the connector area, wherein at least one inner wall (1.2, 2.1) is provided to separate the inner chamber (1.5) from the contacting chamber (1.3), and the circuit board (3) including the electrical components (3.2) is arranged in the inner chamber (1.5), and only the contacting area (3.1) formed from the circuit board protrudes through the inner wall (1.2) into the contacting chamber (1.3),
the housing consists of an upper housing part and a lower housing part, and inner walls are respectively provided on the upper housing part and on the lower housing part and the circuit board is fixed between the upper housing part and the lower housing part by closing the housing, wherein the inner walls respectively extend to the circuit board, jointly forming the inner wall which separates a contacting chamber (1.3) from an inner chamber (1.5).

## Revendications

1. Ensemble électrique pour un véhicule automobile, approprié pour la mise en contact avec un connecteur,
l'ensemble électrique comprenant un boîtier et
un circuit imprimé avec des composants électriques et des pistes conductrices ainsi que des premiers éléments de contact accessibles au connecteur, et ces premiers éléments de contact situés sur l'ensemble sont constitués en tant que surfaces de contact sur le circuit imprimé par le fait qu'une zone de mise en contact du circuit imprimé est constituée avec des pistes conductrices vers ces surfaces de contact, les premiers éléments de contact situés sur l'ensemble étant constitués en tant que contacts marginaux sur le circuit imprimé, **caractérisé en ce que**
le boîtier de l'ensemble présente une chambre intérieure (1.5) et une chambre de mise en contact (1.3) dirigée vers une zone de connecteur (1.1), au moins une paroi intérieure (1.2, 2.1) étant prévue pour la séparation entre la chambre intérieure (1.5) et la chambre de mise en contact (1.3), et le circuit imprimé (3) avec les composants électriques (3.2) étant disposé dans la chambre intérieure (1.5), et seule la zone de mise en contact (3.1) formée sur le circuit imprimé dépassant dans la chambre de mise en contact (1.3) à travers la paroi intérieure (1.2).

2. Ensemble électrique selon la revendication 1, **caractérisé en ce que** le boîtier se compose d'une partie supérieure de boîtier (1) et d'une partie inférieure de boîtier (2), et **en ce que** respectivement une paroi intérieure (1.2, 2.1) est prévue respectivement sur la partie supérieure de boîtier ainsi que sur la partie inférieure de boîtier, et le circuit imprimé (3) est fixé entre la partie supérieure de boîtier (1) et la partie inférieure de boîtier (2), les parois intérieures (2.1, 1.2) dépassant respectivement vers le circuit imprimé (3) et formant conjointement la paroi intérieure pour opérer la séparation entre la chambre de mise en contact (1.3) et la chambre intérieure (1.5).

3. Ensemble électrique selon la revendication 2, **caractérisé en ce que** les parois intérieures (2.1, 1.2) sont disposées dans un plan commun.

4. Ensemble électrique selon la revendication 2 ou 3, **caractérisé en ce que** les parois intérieures (2.1, 1.2) sont raccordées au matériau en matière plastique de la partie supérieure de boîtier (1) et de la partie inférieure de boîtier (2), sont de préférence formées d'une seule pièce réalisée en ce matériau.

5. Ensemble électrique selon l'une des revendications précédentes, **caractérisé en ce que** le boîtier (1.2) de l'ensemble est formé de telle sorte que le connecteur (4) peut être connecté de telle sorte que la connexion du connecteur donne lieu à une unité, étanche à l'humidité, composée de l'ensemble et du connecteur.

6. Ensemble électrique selon la revendication 5, **caractérisé en ce que** la zone de contact (3.1) de l'ensemble est guidée hors du boîtier ou peut être mise en contact de l'extérieur à travers un évidement (1.1.3) du boîtier, et le boîtier (1.2) entoure complètement le circuit imprimé (3) à l'extérieur de la zone de contact.

7. Ensemble électrique selon l'une des revendications précédentes, **caractérisé en ce que** le boîtier est formé d'une coque de boîtier (1) et d'un couvercle de boîtier (2), une collerette de connecteur (1.1) périphérique pour le raccordement d'un connecteur (4) étant prévue sur la coque de boîtier (1), et la coque de boîtier (1) présente une ouverture (1.4) correspondant au moins à la surface du circuit imprimé (3), cette ouverture (1.4) pouvant être complètement fermée par le couvercle de boîtier (2).

8. Véhicule automobile avec un ensemble selon l'une des revendications 1 à 7.

9. Procédé de fabrication d'un ensemble selon la revendication 2,
l'ensemble électrique présentant un boîtier et un circuit imprimé avec des composants électriques et des pistes conductrices,
des premiers éléments de contact disposés dans l'intérieur du boîtier, toutefois accessibles pour le connecteur à travers une zone de connecteur (1.1), étant prévus, et ces premiers éléments de contact situés sur l'ensemble étant constitués en tant que surfaces de contact sur le circuit imprimé par le fait qu'une zone de mise en contact du circuit imprimé est constituée avec des pistes conductrices vers ces surfaces de contact, et les premiers éléments de contact situés sur l'ensemble sont constitués en tant que contacts marginaux sur le circuit imprimé,
le boîtier de l'ensemble présentant une chambre intérieure (1.5) et une chambre de mise en contact (1.3) dirigée vers la zone de connecteur, au moins une paroi intérieure (1.2, 2.1) étant prévue pour la séparation entre la chambre intérieure (1.5) et la chambre de mise en contact (1.3), et le circuit imprimé (3) avec les composants électriques (3.2) étant disposé dans la chambre intérieure (1.5), et seule la zone de mise en contact (3.1) formée à partir du circuit imprimé dépassant dans la chambre de mise en contact (1.3) à travers la paroi intérieure (1.2), le boîtier se composant d'une partie supérieure de boîtier et d'une partie inférieure de boîtier, et une paroi intérieure étant prévue respectivement sur la partie supérieure de boîtier ainsi que sur la partie inférieure de boîtier, et le circuit imprimé étant fixé entre la partie supérieure de boîtier et la partie inférieure de boîtier par la fermeture du boîtier, les parois intérieures dépassant respectivement vers le circuit imprimé et formant conjointement la paroi intérieure pour opérer la séparation entre une chambre de mise en contact (1.3) et une chambre intérieure (1.5).
